# EUROPEAN PATENT SPECIFICATION

(11) **EP 3 316 033 B1**
(45) Date of publication and mention of the grant of the patent: **02.10.2019**
(21) Application number: 17199463.5
(22) Date of filing: 31.10.2017
(51) Int. Cl.: G02F 1/1362, G02F 1/1368

(54) **THIN FILM TRANSISTOR SUBSTRATE HAVING COLOR FILTER**
DÜNNFILMTRANSISTORSUBSTRAT MIT FARBFILTER
SUBSTRAT DE TRANSISTOR À FILM MINCE AYANT UN FILTRE DE COULEUR

(30) Priority: 31.10.2016 KR 20160144000
(43) Date of publication of application: 02.05.2018
(73) Proprietor: LG Display Co., Ltd., Seoul, 07336 (KR)
(72) Inventor: WOO, Changseung, 10845 Gyeonggi-do (KR); LEE, Byunghyun, 10845 Gyeonggi-do (KR); HONG, Soonhwan, 10845 Gyeonggi-do (KR); WON, Gyusik, 10845 Gyeonggi-do (KR)
(74) Representative: Morrall, Jonathan Ian McLachlan

(56) References cited:
- KR-B1- 100 959 366
- US-A1- 2003 020 851
- US-A1- 2005 078 252
- US-A1- 2005 253 984
- US-B2- 7 561 229

## Description

### Field

The present disclosure relates to a thin film transistor substrate having a color filter layer. In particular, the present disclosure relates to a thin film transistor substrate in which color filter layers are formed with a thin film transistor and a color filter layer is used as an intermediate insulating layer of the thin film transistor.

### Background

A liquid crystal display (LCD) device displays video data by controlling the opacity of a liquid crystal layer using an electric field. According to the direction of the electric field, the LCD can be classified into two major types: a vertical electric field type and a horizontal electric field type.

For the vertical electric field type LCD, a common electrode formed on an upper substrate and a pixel electrode formed on a lower substrate face each other in order to form an electric field that is perpendicular to the substrate face. A twisted nematic (TN) liquid crystal layer disposed between the upper substrate and the lower substrate is formed by the vertical electric field. The vertical electric field type LCD has the advantage of a higher aperture ratio, but the disadvantage of a narrower viewing angle of about 90 degrees.

Regarding the horizontal electric field type LCD, a common electrode and a pixel electrode are formed on the same substrate in parallel. A liquid crystal layer disposed between an upper substrate and a lower substrate is driven in an In-Plane-Switching (or 'IPS') mode by an electric field parallel to the substrate face. The horizontal electric field type LCD has the advantage of a wider viewing angle of over 170 degrees and a faster response speed than the vertical electric field type LCD. However, the horizontal electric field type LCD may have disadvantages such as a low aperture ratio and backlight transmission ratio.

The liquid crystal display widely used in current displays has a structure in which a thin film transistor substrate having a plurality of thin film transistors arrayed in a matrix is joined with a color filter substrate having a plurality of color filters, and a liquid crystal layer is inserted between these two substrates. Alternatively, a liquid crystal display has a structure in which a lower substrate comprises color filters and thin film transistors are joined with an upper substrate, and a liquid crystal layer is inserted between these two substrates.

The structure wherein a color filter is formed on a thin film transistor is called a color filter on thin film transistor (or COT) structure. As the thin film transistor and the color filter are formed on the same substrate, the manufacturing process of the COT structure is simpler than for other structures. Further, as an alignment margin is not of concern when joining the two substrates, a high aperture ratio can be easily acquired.

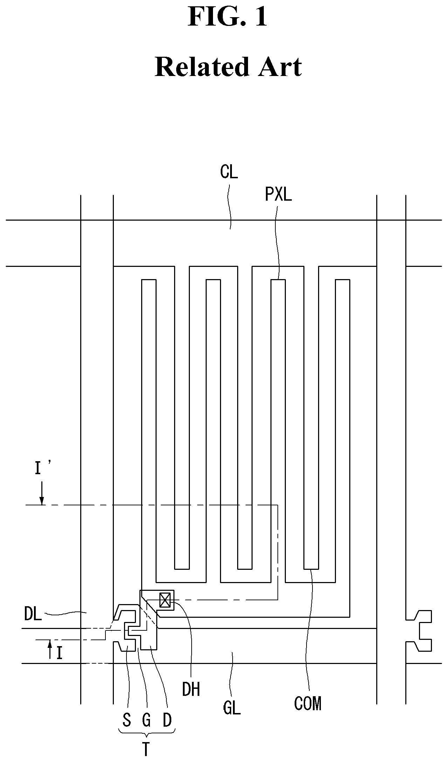

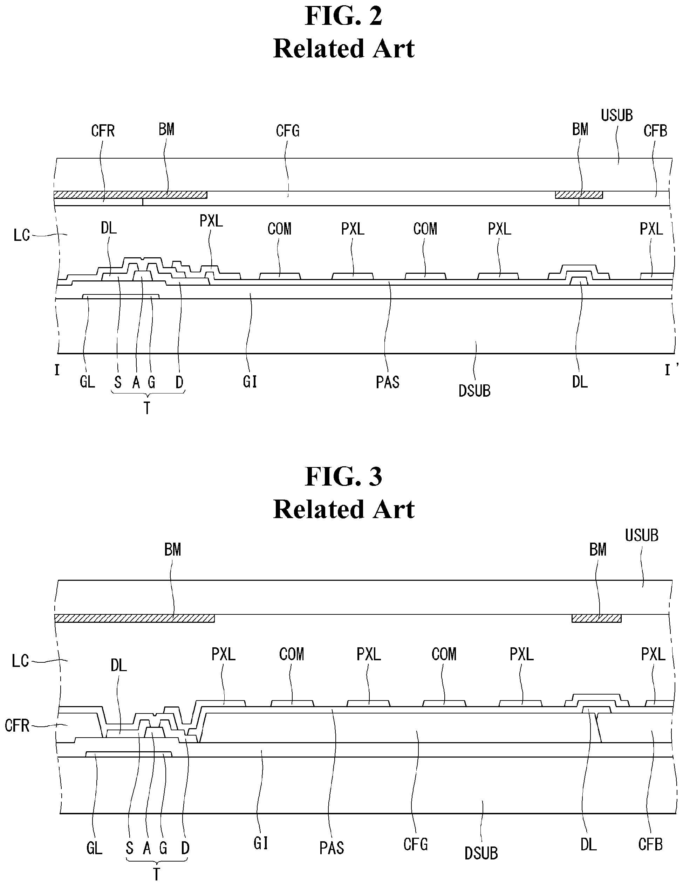

FIG. 1 is a plan view illustrating a thin film transistor substrate for a horizontal field type liquid crystal display according to the related art. FIG. 2 is a cross-sectional view illustrating the structure of the thin film transistor substrate of FIG. 1 by cutting along the line I-I' according to the related art.

Referring to FIGs. 1 and 2, the thin film transistor substrate of the horizontal field type liquid crystal display has a structure in which a (transparent) upper substrate USUB is attached to a (transparent) lower substrate DSUB with a liquid crystal layer LC there-between.

A plurality of color filters CFR, CFG and CFB is disposed in a matrix on the inner surface of the upper substrate USUB. In addition, between each neighboring color filter, a black matrix BM is disposed. The black matrix BM defines each pixel area and one color filter is allocated per pixel area.

On the lower substrate DSUB, a gate line GL running in the horizontal direction and a data line DL running in the vertical direction are disposed. It is preferable that the gate line GL and the data line DL are aligned with the black matrix of the upper substrate USUB. The pixel areas arrayed in a matrix are defined by the gate lines GL and the data lines DL crossing each other and having a gate insulating layer there-between.

At one corner of each pixel area, a thin film transistor is disposed; the thin film transistor includes a gate electrode G extending from the gate line GL, a source electrode S extending from the data line DL and a drain electrode D facing the source electrode S and a predetermined distance from the source electode S. A semiconductor layer A overlaps the gate electrode G on the gate insulating layer GI covering the gate electrode G. One side portion of the semiconductor layer A contacts the source electrode S and the other side portion of the semiconductor layer A contacts the drain electrode D.

A passivation layer PAS is disposed on the thin film transistor T for protecting the electronic elements. On the passivation layer PAS, a pixel electrode PXL and a common electrode COM are formed of a transparent conductive material. The pixel electrode PXL contacts the drain electrode D through a drain contact hole DH formed in the passivation layer PAS. The pixel electrode PXL has a comb shape in which a plurality of segments is arrayed in parallel with a predetermined distance between them. The common electrode COM also has a comb shape in which a plurality of segments is arrayed in parallel with a predetermined distance between them, and alternatly positioned bewteen the pixel electrode PXL segments.

Further, the common electrode COM is connected to a common line CL being parallel with the gate line GL. As a result, an electric field is formed in a horizontal direction with respect to the surface of the lower substrate DSUB between the pixel electrode PXL and the common electrode COM. The liquid crystal layer LC disposed between the upper substrate USUB and the lower substrate DSUB is driven by the horizontal electric field.

In the case of a thin film transistor substrate having a COT structure, the thin film transistor and the color filter are formed on the same substrate. FIG. 3 is a cross sectional view illustrating the structure of a thin film transistor substrate for a liquid crystal display having a color filter and thin film transistor on the same substrate in accordance with the related art. The liquid crystal display with COT structure comprises an upper substrate USUB, a lower substrate DSUB and a liquid crystal layer LC inserted between these two substrates. On the lower substrate DSUB, the thin film transistor T and the color filters CFR, CFG and CFB are formed together.

For example, as shown in FIG. 3, a color filter CF is inserted between the gate insulating layer GI and the passivation layer PAS. In this case, the upper substrate USUB has other elements not related to video display functions, such as spacers. The liquid crystal display is formed by joining the upper substrate USUB with the lower substrate DSUB comprising color filters CF and a thin film transistor T, and by injecting a liquid crystal layer LC between the two substrates.

Even though the COT structure has some merits, the manufacturing process is complicated because the color filters are formed on the substrate comprising the thin film transistors. For example, the color filter CF includes three sub color filters representing the color red R, the color green G and the color blue B. Therefore, at least three mask processes are required to form the color filter CF. As the manufacturing processes are complicated, the manufacturing yields are reduced. Therefore, in order to take advantage of the merits of a COT structure, simplified manufacturing processes are required. Further, a liquid crystal display adopting this new COT structure made according to these manufacturing processes is required.

US7561229 discloses a TFT array substrate with a stack of two colour filter layers and an overcoat layer above the TFT. US2005253984 and US2005078252 disclose a TFT array substrate with a stack of three colour filter layers above the TFT. US2003020851 discloses a TFT array substrate with a colour filter layer below the TFT. KR100959366 discloses a TFT array substrate with a colour filter layer and a top gate TFT.

### SUMMARY

In order to overcome the above mentioned drawbacks, the purpose of the present disclosure is to provide a liquid crystal display with a thin film transistor and color filter on the same substrate. Another purpose arim of the present disclosure is to provide a thin film transistor substrate for a liquid crystal display with a high aperture ratio wherein an alignment margin when joining two substrates is not an issue. Yet another purpose of the present disclosure is to provide a thin film transistor substrate for a liquid crystal display with an ultra high resolution and ultra high aperture ratio.

In order to accomplish the above purposes, one embodiment of the present disclosure provides a thin film transistor substrate comprising: a plurality of pixel areas disposed in a matrix on a substrate, each pixel area including an aperture area and a non-aperture area; a first color filter and a second color filter stacked at the non-aperture area on the substrate; an overcoat layer disposed on the first color filter and the second color filter; a semiconductor layer disposed at the non-aperture area on the overcoat layer; a gate insulating layer and a gate electrode stacked on a middle portion of the semiconductor layer; a third color filter at the non-aperture area on the semiconductor layer and the gate electrode; and a source electrode and a drain electrode disposed on the third color filter.

In some embodiments, the thin film transistor substrate further comprises: a planar layer on the source electrode and the drain electrode; a common electrode on the planar layer; a passivation layer on the common electrode; and a pixel electrode contacting the drain electrode on the passivation layer.

In some embodiments, each of the first color filter, the second color filter and the third color filter is any one of a red color filter, a green color filter and a blue color filter.

In some embodiments, the thin film transistor substrate further comprises: a gate line connected to the gate electrode and running in a first direction on the substrate; and a data line connected to the source electrode and running in a second direction on the substrate, wherein the pixel area is defined as an area surrounded by the gate line and the data line.

In some embodiments, the common electrode includes a transparent conductive material covering the aperture area of the pixel area and covering all pixel areas; and the pixel electrode includes the transparent conductive material having a plurality of segments disposed parallel each other with a predetermined distance within the aperture area of the pixel area.

In some embodiments, the pixel areas include a first color pixel area, a second color pixel area and a third colour pixel area.

In some embodiments, the first color filter is further disposed at the aperture area of the first color pixel area, the second color filter is further disposed at the aperture area of the second color pixel area, and the third color filter is further disposed at the aperture area of the third color pixel area.

In some embodiments, the thin film transistor substrate further comprises: an intermediate insulating layer on the semiconductor layer and the gate electrode, and under the third color filter.

The thin film transistor substrate for the liquid crystal display according to the present disclosure comprises a thin film transistor and a color filter on the same substrate. Therefore, the alignment margin for joining two substrates is not an issue, such that a high aperture ratio is ensured. In particular, the present disclosure suggests an optimum structure to achieve a high aperture ratio for a liquid crystal display with an ultra high density resolution over UHD resolution (or 4K resolution) with an extremely small pixel area. By stacking at least two color filters at the non-aperture area when forming the color filters on a substrate, a black matrix is not required. Further, using a color filter in place of an intermediate insulating layer, the manufacturing process is simplified.

### BRIEF DESCRIPTION OF THE DRAWINGS

The accompanying drawings, which are included to provide a further understanding of the disclosure and are incorporated in and constitute a part of this specification, illustrate embodiments of the invention and together with the description serve to explain the principles of the disclosure.
FIG. 1 is a plan view illustrating a thin film transistor substrate for a horizontal field type liquid crystal display according to the related art.
FIG. 2 is a cross-sectional view illustrating the structure of the thin film transistor substrate of FIG. 1 by cutting along the line I-I' according to the related art.
FIG. 3 is a cross sectional view illustrating the structure of the thin film transistor substrate of a liquid crystal display with color filter and thin film transistor on the same substrate according to the related art.
FIG. 4 is a plan view illustrating the structure of a liquid crystal display according to a first embodiment of the present disclosure.
FIG. 5 is a cross sectional view illustrating the structure of a liquid crystal display by cutting along the line I-I' according to the first embodiment of the present disclosure.
FIGs. 6 to 8 are plan views illustrating the patterns of the color filters according to the first embodiment of the present disclosure.
FIG. 9 is a cross sectional view illustrating a structure of a liquid crystal display according to a second embodiment of the present disclosure.

### DETAILED DESCRIPTION

Referring to the figures, preferred embodiments of the present disclosure will be described. Like reference numerals designate like elements throughout the detailed description. However, the present disclosure is not restricted by these embodiments and can be applied to various changes or modifications. In the following embodiments, the names of the elements are selected for ease of explanation and may be different from actual names.

### <First Embodiment>

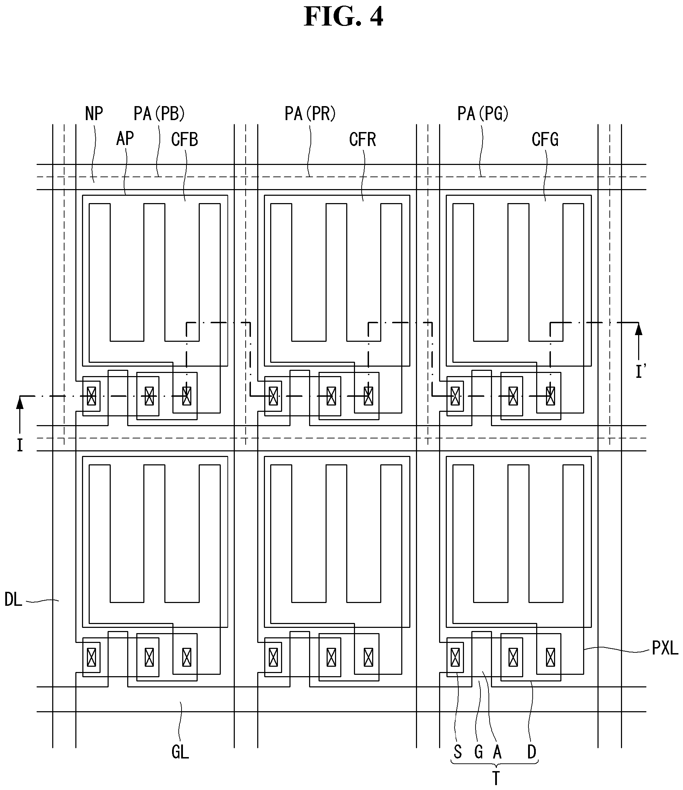

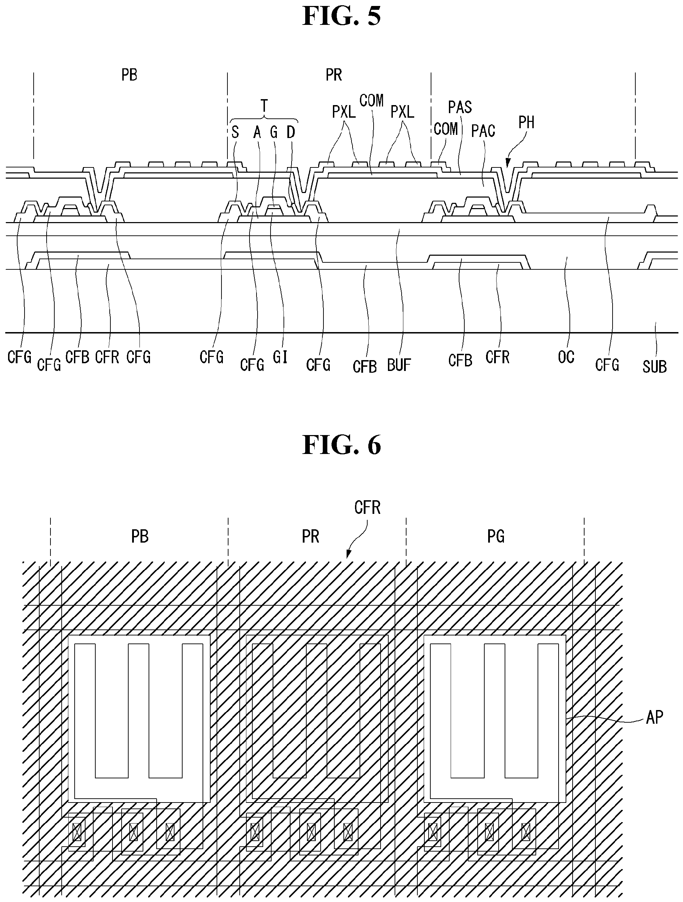

Referring to FIGs. 4 to 8, the first embodiment of the present disclosure will be explained. FIG. 4 is a plan view illustrating the structure of a liquid crystal display according to the first embodiment of the present disclosure. FIG. 5 is a cross sectional view illustrating the structure of a liquid crystal display by cutting along the line I-I' according to the first embodiment of the present disclosure. FIGs. 6 to 8 are plan views illustrating the patterns of the color filters according to the first embodiment of the present disclosure.

Referring to FIGs. 4 and 5, the liquid crystal display according to the first embodiment of the present disclosure comprises a gate line GL running in a first (i.e., horizontal) direction and a data line DL running in a second (i.e., vertical) direction on a substrate SUB. As a plurality of the gate lines GL crosses a plurality of the data lines DL, a plurality of pixel areas PA is defined as arraying or being formed in a matrix. At each pixel area, a thin film transistor T and a pixel electrode PXL connected to the thin film transistor T are disposed.

The pixel area PA includes an aperture area AP that shows an image representative of input data and a non-aperture area NP that does not transmit light. At the non-aperture area NP, the gate line GL, the data line DL and the thin film transistor T are disposed. At the aperture area AP, the pixel electrode PXL and the common electrode COM are disposed.

In the cross sectional view of FIG. 5, a red color filter CFR is deposited on a substrate SUB. Further, the plan view of FIG. 6 illustrates an area where the red color filter CFR is deposited. Referring to FIG. 6, the red color filter CFR is deposited at the aperture area AP of the red pixel area PR. In addition, the red color filter CFR covers all non-aperture areas NP but not aperture areas AP of blue pixel area PB and green pixel area PG.

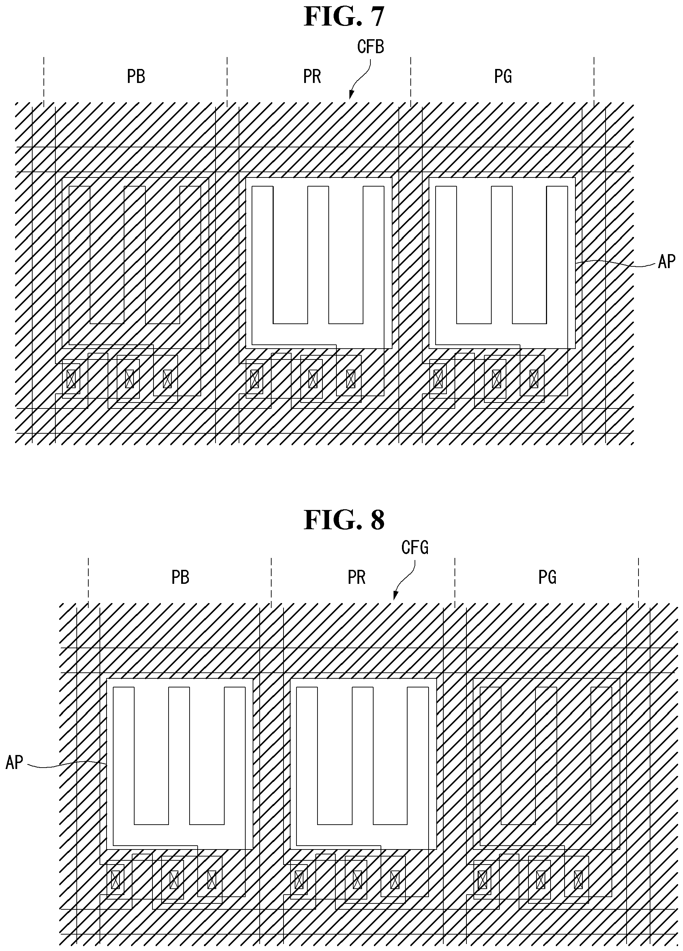

In the cross sectional view, a blue color filter CFB is stacked on the red color filter CFR. The plan view point of FIG. 7 illustrates an area where the blue color filter CFB is deposited. Referring to FIG. 7, the blue color filter CFB is deposited at the aperture area AP of the blue pixel area PB. In addition, the blue color filter CFB covers all non-aperture areas NP but not aperture areas AP of the red pixel area PR and the green pixel area PG. As a result, at the non-aperture areas NP, the blue color filter CFB is directly stacked on the red color filter CFR.

In the cross sectional view, on the whole of the surface of the substrate SUB comprising the red color filter CFR and the blue color filter CFB, an overcoat layer OC is deposited. The overcoat layer OC may make the surface of the substrate SUB even and/or smooth if the surface of the substrate SUB is uneven due to the stacked red color filter CFR and blue color filter CFB.

On the overcoat layer OC, a buffer layer BUF may be deposited. The overcoat layer OC may include an organic material. When the thin film transistor is directly formed on the overcoat layer OC, some defects may form at the interface. In order to prevent the formation of defects, a buffer layer BUF is formed on the overcoat layer OC using a material that forms a good interface with an organic material and/or with an inorganic material.

On the buffer layer BUF, a semiconductor layer A is formed. A gate insulating layer GI and a gate electrode G are formed over the middle portion of the semiconductor layer A. The gate insulating layer GI and the gate electrode G have the same shape. The overlapped areas of the semiconductor layer A with the gate electrode G are defined as the channel area. One side of the channel area is defined as the source area and the other side of the channel area is defined as the drain area.

A green color filter CFG is deposited on the substrate SUB with the semiconductor layer A and the gate electrode G. The plan view of FIG. 8 illustrates an area where the green color filter CFG is deposited. Referring to FIG. 8, the green color filter CFG is disposed at the aperture area AP of the green pixel area PG. In addition, the green color filter CFG covers all non-aperture areas NP but not the aperture areas AP of the blue pixel area PB and the red pixel area PR.

As the semiconductor layer A and the gate electrode G are disposed at the non-aperture area NP, the green color filter CFG covers all of the semiconductor layers A disposed at all pixel areas including the blue pixel area PB, the red pixel area PR and the green pixel area PG. The green color filter CFG has contact holes for exposing the source area and the drain area of the semiconductor layer A. That is, the green color filter CFG is used as an intermediate insulating layer covering the gate electrode G.

On the green color filter CFG, a data line DL, a source electrode S and a drain electrode D are formed. The source electrode S extends from the data line DL and contacts the source area of the semiconductor layer A. The drain electrode D contacts the drain area of the semiconductor layer A. Thus, the thin film transistor T is completed.

On the thin film transistor T, a planar layer PAC is deposited to cover the whole surface of the substrate SUB. A pixel contact hole PH is formed at the planar layer PAC to expose the drain electrode D. On the planar layer PAC, a common electrode COM is formed. The common electrode COM may be a transparent conductive layer deposited over the whole surface of the substrate. It is preferable that the common electrode COM does not cover the pixel contact hole PH.

On the common electrode COM, a passivation layer PAS is deposited to cover the whole surface of the substrate SUB. The passivation layer PAS also has the pixel contact hole PH for exposing the drain electrode D. On the passivation layer PAS, a pixel electrode PXL is formed. The pixel electrode PXL contacts the drain electrode D through the pixel contact hole PH.

A thin film transistor substrate having color filters CFR, CFG and CFB according to the present disclosure has a structure in which the red color filter CFR, the blue color filter CFB and the green color filter CFG are sequentially stacked at a non-aperture area NP. Therefore, without an extra black matrix, the stacked color filters CFR, CFG and CFB effectively provide a black matrix between neighboring pixel areas. In addition, the green color filter CFG provides an intermediate insulating layer between a gate line GL and a data line DL. As a result, the masking processes required to form a black matrix and intermediate insulating layer are not required. In other words, the manufacturing process for the liquid crystal display according to the present disclosure requires at least two fewer masking processes when compared to the related art. Thus, manufacturing tack time can be shortened and manufacturing turnover can be increased.

A red color filter CFR, green color filter CFG and blue color filter CFB are formed with a thin film transistor T and a pixel electrode PXL on the same substrate SUB. A black matrix is formed by stacking the color filters. Therefore, mis-alignment cannot occur so that an aligning margin is not an issue during manufacturing. As a result, the aperture ratio has a maximum value.

In the above description, color filters are stacked in the order of red, blue and then green. However, the disclosure is not restricted to this stacking order. If required, the stacking order may be different. Preferably, a color filter used for the intermediate insulating layer is a green color filter CFG. Contact holes exposing a source area and a drain area of a semiconductor layer A may be more readily formed in a green color filter CFG.

### <Second Embodiment>

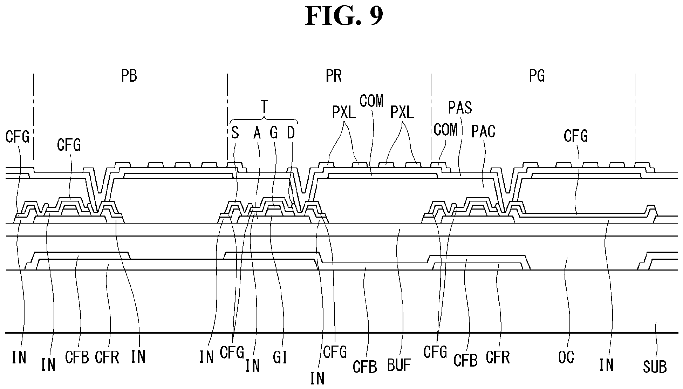

Hereinafter, referring to FIG. 9, a second embodiment of the present disclosure will be described. Regarding the first embodiment, the structure of a liquid crystal display in which a green color filter is used for an intermediate insulating layer has been described. Regarding the second embodiment, the structure of a liquid crystal display in which an extra intermediate insulating layer is included will now be explained. FIG. 9 is a cross sectional view illustrating the structure of a liquid crystal display according to a second embodiment of the present disclosure.

The structure of the liquid crystal display according to the second embodiment of the present disclosure is similar to that of the first embodiment. A difference is that an additional intermediate insulating layer is included under the green color filter.

Referring to FIG. 9, a red color filter CFR is deposited on a substrate SUB. The red color filter CFR has the same pattern as in the first embodiment. The red color filter CFR may be deposited in the hatched area shown in FIG. 6. For example, the red color filter CFR is deposited in the aperture area AP of the red pixel area PR. In addition, the red color filter CFR covers all non-aperture areas NP except aperture areas AP of the blue pixel area PB and the green pixel area PG.

In the cross sectional view of FIG. 9, it can be seen that a blue color filter CFB is stacked on the red color filter CFR. The blue color filter CFB has the same pattern as in the first embodiment. The blue color filter CFB may be deposited at the hatched area shown in FIG. 7. For example, the blue color filter CFB is deposited at the aperture area AP of the blue pixel area PB. In addition, the blue color filter CFB covers all non-aperture areas NP except aperture areas AP of the red pixel area PR and the green pixel area PG. As a result, at the non-aperture area NP, the blue color filter CFB is directly stacked on the red color filter CFR.

In the cross sectional view of FIG. 9, it can be seen that on the whole surface of the substrate SUB having the red color filter CFR and the blue color filter CFB, an overcoat layer OC is deposited. The overcoat layer OC may make the surface of the substrate SUB even and/or smooth, if the surface is uneven due to the stacked red color filter CFR and blue color filter CFB.

On the overcoat layer OC, a buffer layer BUF may be deposited. The overcoat layer OC may include an organic material. When the thin film transistor is directly formed on the overcoat layer OC, some defects may form at the interface. In order to prevent the defects, a buffer layer BUF is formed on the overcoat layer OC, using a material that forms a good interface with an organic material and/or with an inorganic material.

On the buffer layer BUF, a semiconductor layer A is formed. A gate insulating layer GI and a gate electrode G are formed over a middle portion of the semiconductor layer A. The gate insulating layer GI and the gate electrode G have the same shape. The overlapped areas of the semiconductor layer A with the gate electrode G are defined as a channel area. One side of the channel area is defined as the source area and the other side of the channel area is defined as the drain area.

An intermediate insulating layer IN is deposited on the substrate SUB having the semiconductor layer A and the gate electrode G. A green color filter CFG is deposited on the intermediate insulating layer IN. The green color filter may have the same pattern as in first embodiment. The plan view of FIG. 8 illustrates an area where the green color filter CFG is deposited. Referring to FIG. 8, the green color filter CFG is disposed at the aperture area AP of the green pixel area PG. In addition, the green color filter CFG covers all non-aperture areas NP except the aperture areas AP of the blue pixel area PB and the red pixel area PR. The intermediate insulating layer IN may cover the same area and have the same pattern as the green color filter CFG.

On the intermediate insulating layer IN, a data line DL, a source electrode S and a drain electrode D are formed. The intermediate insulating layer IN and the green color filter CFG have contact holes for exposing the source area and the drain area of the semiconductor layer A. The source electrode S extends from the data line DL and contacts the source area of the semiconductor layer A. The drain electrode D contacts the drain area of the semiconductor layer A. Thus, the thin film transistor T is completed.

On the thin film transistor T, a planar layer PAC is deposited to cover the whole surface of the substrate SUB. A pixel contact hole PH is formed at the planar layer PAC for exposing the drain electrode D. On the planar layer PAC, a common electrode COM is formed. The common electrode COM may be a transparent conductive layer deposited on the whole surface of the substrate. It is preferable that the common electrode COM does not cover the pixel contact hole PH.

On the common electrode COM, a passivation layer PAS is deposited to cover the whole surface of the substrate SUB. The passivation layer PAS also has a pixel contact hole PH for exposing the drain electrode D. On the passivation layer PAS, a pixel electrode PXL is formed. The pixel electrode PXL contacts the drain electrode D through the pixel contact hole PH.

The thin film transistor substrate having color filters CFR, CFG and CFB according to the present disclosure has a structure in which the red color filter CFR, the blue color filter CFB and the green color filter CFG are sequentially stacked at a non-aperture area NP. Therefore, without a black matrix, the stacked color filters CFR, CFG and CFB work as a black matrix between neighboring pixel areas. In addition, the intermediate insulating layer IN is stacked under the green color filter CFG and patterned with the green color filter CFG at the same time, so that the intermediate insulating layer IN has the same shape as the green color filter CFG. As a result, the mask processes required for forming a black matrix and an intermediate insulating layer are not required. In other words, the manufacturing process for a liquid crystal display according to the present disclosure requires at least two fewer masking processes than in the related art. Thus, the manufacturing tack time can be shortened and the manufacturing yield can be increased.

The color filters including the red color filter CFR, the green color filter CFG and the blue color filter CFB are formed with the thin film transistor T and the pixel electrode PXL on the same substrate SUB. The black matrix is formed by stacking the color filters. Therefore, mis-alignment cannot occur so that the problem of an aligning margin is not an issue. As a result, the aperture ratio has a maximum value.

In the above description, the color filters are stacked in the order of red, blue and then green. However, the embodiment is not restricted to this stacking order. If required, the stacking order may be different. Preferably, the color filter deposited over the intermediate insulating layer IN is the green color filter CFG. Contact holes exposing a source area and a drain area of a semiconductor layer A may be more readily formed in a green color filter CFG.

While the embodiment of the present invention has been described in detail with reference to the drawings, it will be understood by those skilled in the art that the invention can be implemented in other specific forms without changing the essential features of the disclosure. Therefore, it should be noted that the forgoing embodiments are merely illustrative in all aspects and are not to be construed as limiting the disclosure. The scope of the disclosure is defined by the appended claims rather than the detailed description of the invention. All changes or modifications made within the scope of the claims should be construed as falling within the scope of the disclosure.

## Claims

1. A thin film transistor substrate, comprising:
a plurality of pixel areas (PA) disposed in a matrix manner on a substrate (SUB), each pixel area including an aperture area (AP) and a non-aperture area (NP);
a first color filter (CF) and a second color filter (CF) stacked at the non-aperture area on the substrate;
an overcoat layer (OC) disposed on the first color filter and the second color filter;
a semiconductor layer (A) disposed at the non-aperture area and on the overcoat layer;
a gate insulating layer (GI) and a gate electrode (G) stacked on a middle portion of the semiconductor layer;
a third color filter (CF) at the non-aperture area on the semiconductor layer and the gate electrode; and
a source electrode (S) and a drain electrode (D) disposed on the third color filter.

2. The thin film transistor substrate according to claim 1, further comprising:
a planar layer (PAC) on the source electrode and the drain electrode;
a common electrode (COM) on the planar layer;
a passivation layer (PAS) on the common electrode; and
a pixel electrode (PXL) contacting the drain electrode on the passivation layer.

3. The thin film transistor substrate according to claim 2,
wherein the common electrode includes a transparent conductive material covering the aperture area of each pixel area; and
wherein the pixel electrode includes the transparent conductive material having a plurality of segments disposed as being parallel to each other with a predetermined distance within the aperture area of each pixel area.

4. The thin film transistor substrate according to any preceeding claim, wherein each pixel area includes a first color pixel area, a second colour pixel area and a third colour pixel area.

5. The thin film transistor substrate according to claim 4,
wherein the first color filter is disposed at the aperture area of the first color pixel area,
wherein the second color filter is disposed at the aperture area of the second color pixel area, and
wherein the third color filter is disposed at the aperture area of the third color pixel area.

6. The thin film transistor substrate according to claim 5, further comprising:
an intermediate insulating layer (IN) on the semiconductor layer and the gate electrode, and under the third color filter.

7. The thin film transistor substrate according to any preceeding claim, wherein each of the first color filter, the second color filter and the third color filter is any one of a red color filter (CFR), a green color filter (CFG) and a blue color filter (CFB).

8. The thin film transistor substrate according to any preceding claim, further comprising:
a gate line (GL) connected to the gate electrode and running in a first direction on the substrate; and
a data line (DL) connected to the source electrode and running in a second direction on the substrate,
wherein each pixel area of the plurality of the pixel areas is defined as an area surrounded by the gate line and the data line.

9. A liquid crystal display device comprising a thin film transistor substrate according to any preceding claim.

## Patentansprüche

1. Dünnschichttransistorsubstrat, das Folgendes umfasst:
mehrere Pixelbereiche (PA), die in einer Matrix auf einem Substrat (SUB) angeordnet sind, wobei jeder Pixelbereich einen Aperturbereich (AP) und einen Nichtaperturbereich (NP) aufweist;
einen ersten Farbfilter (CF) und einen zweiten Farbfilter (CF), die bei dem Nichtaperturbereich auf dem Substrat gestapelt sind;
eine Mantellage (OC), die auf dem ersten Farbfilter und dem zweiten Farbfilter angeordnet ist;
eine Halbleiterlage (A), die bei dem Nichtaperturbereich und auf der Mantellage angeordnet ist;
eine Gate-Isolierungslage (GI) und eine Gate-Elektrode (G), die auf einem mittleren Abschnitt der Halbleiterlage gestapelt sind;
einen dritten Farbfilter (CF) bei dem Nichtaperturbereich auf der Halbleiterlage und der Gate-Elektrode; und
eine Source-Elektrode (S) und eine Drain-Elektrode (D), die auf dem dritten Farbfilter angeordnet sind.

2. Dünnschichttransistorsubstrat nach Anspruch 1, das ferner Folgendes umfasst:
eine ebene Lage (PAC) auf der Source-Elektrode und der Drain-Elektrode;
eine gemeinsame Elektrode (COM) auf der ebenen Lage;
eine Passivierungslage (PAS) auf der gemeinsamen Elektrode; und
eine Pixelelektrode (PXL), die auf der Passivierungslage mit der Drain-Elektrode in Kontakt ist.

3. Dünnschichttransistorsubstrat nach Anspruch 2,
wobei die gemeinsame Elektrode ein lichtdurchlässiges leitfähiges Material umfasst, das den Aperturbereich jedes Pixelbereichs bedeckt; und
wobei die Pixelelektrode das lichtdurchlässige leitfähige Material umfasst, das mehrere Segmente aufweist, die so angeordnet sind, dass sie mit einem festgelegten Abstand in dem Aperturbereich des jeweiligen Pixelbereichs parallel zueinander liegen.

4. Dünnschichttransistorsubstrat nach einem der vorhergehenden Ansprüche, wobei jeder Pixelbereich einen Pixelbereich einer ersten Farbe, einen Pixelbereich einer zweiten Farbe und einen Pixelbereich einer dritten Farbe umfasst.

5. Dünnschichttransistorsubstrat nach Anspruch 4,
wobei der erste Farbfilter bei dem Aperturbereich des Pixelbereichs einer ersten Farbe angeordnet ist,
wobei der zweite Farbfilter bei dem Aperturbereich des Pixelbereichs einer zweiten Farbe angeordnet ist und
wobei der dritte Farbfilter bei dem Aperturbereich des Pixelbereichs einer dritten Farbe angeordnet ist.

6. Dünnschichttransistorsubstrat nach Anspruch 5, das ferner Folgendes umfasst:
eine isolierende Zwischenlage (IN) auf der Halbleiterlage und der Gate-Elektrode und unter dem dritten Farbfilter.

7. Dünnschichttransistorsubstrat nach einem der vorhergehenden Ansprüche, wobei der erste Farbfilter, der zweite Farbfilter und der dritte Farbfilter ein roter Farbfilter (CFR), ein grüner Farbfilter (CFG) oder ein blauer Farbfilter (CFB) ist.

8. Dünnschichttransistorsubstrat nach einem der vorhergehenden Ansprüche, das ferner Folgendes umfasst:
eine Gate-Leitung (GL), die mit der Gate-Elektrode verbunden ist und auf dem Substrat in einer ersten Richtung verläuft; und
eine Datenleitung (DL), die mit der Source-Elektrode verbunden ist und auf dem Substrat in einer zweiten Richtung verläuft,
wobei jeder Pixelbereich der mehreren Pixelbereiche als ein Bereich definiert ist, der von der Gate-Leitung und der Datenleitung umgeben ist.

9. Flüssigkristallanzeigevorrichtung, die ein Dünnschichttransistorsubstrat nach einem der vorhergehenden Ansprüche umfasst.

## Revendications

1. Substrat de transistor à couches minces, comprenant :
une pluralité de zones de pixels (P) disposée en matrice sur un substrat (SUB), chaque zone de pixel comportant une zone d'ouverture (AP) et une zone de non-ouverture (NP) ;
un premier filtre de couleur (CF) et un deuxième filtre de couleur (CF) empilés au niveau de la zone de non-ouverture sur le substrat ;
une couche de revêtement (C) disposée sur le premier filtre de couleur et le deuxième filtre de couleur ;
une couche semi-conductrice (a) disposée au niveau de la zone de non-ouverture et sur la couche de revêtement ;
une couche isolante de grille (GI) et une électrode de grille (G) empilées sur une partie centrale de la couche semi-conductrice ;
un troisième filtre de couleur (CF) au niveau de la zone de non-ouverture sur la couche semi-conductrice et l'électrode de grille ; et
une électrode de source (S) et une électrode de drain (D) disposées sur le troisième filtre de couleur.

2. Substrat de transistor à couches minces selon la revendication 1, comprenant en outre :
une couche planaire (PAC) sur l'électrode de source et l'électrode de drain ;
une électrode commune (COM) sur la couche planaire ;
une couche de passivation (PAS) sur l'électrode commune ; et
une électrode de pixel (PXL) faisant contact avec l'électrode de drain sur la couche de passivation.

3. Substrat de transistor à couches minces selon la revendication 2,
dans lequel l'électrode commune comporte un matériau conducteur transparent couvrant la zone d'ouverture de chaque zone de pixel ; et
dans lequel l'électrode de pixel comporte le matériau conducteur transparent présentant une pluralité de segments disposés parallèlement les uns aux autres avec une distance prédéterminée en-deçà de la zone d'ouverture de chaque zone de pixel.

4. Substrat de transistor à couches minces selon n'importe quelle revendication précédente, dans lequel chaque zone de pixel comporte une première zone de pixel de couleur, une deuxième zone de pixel de couleur et une troisième zone de pixel de couleur.

5. Substrat de transistor à couches minces selon la revendication 4,
dans lequel le premier filtre de couleur est disposé au niveau de la zone d'ouverture de la première zone de pixel de couleur,
dans lequel le deuxième filtre de couleur est disposé au niveau de la zone d'ouverture de la deuxième zone de pixel de couleur, et
dans lequel le troisième filtre de couleur est disposé au niveau de la zone d'ouverture de la troisième zone de pixel de couleur.

6. Substrat de transistor à couches minces selon la revendication 5, comprenant en outre :
une couche isolante intermédiaire (IN) sur la couche semi-conductrice et l'électrode de grille, et en dessous du troisième filtre de couleur.

7. Substrat de transistor à couches minces selon n'importe quelle revendication précédente, dans lequel chacun du premier filtre de couleur, du deuxième filtre de couleur et du troisième filtre de couleur est n'importe lequel d'un filtre de couleur rouge (CFR), d'un filtre de couleur verte (CFG) et d'un filtre de couleur bleue (CFB).

8. Substrat de transistor à couches minces selon n'importe quelle revendication précédente, comprenant en outre
une ligne de grille (GL) connectée à l'électrode de grille et s'étendant dans une première direction sur le substrat, et
une ligne de données (DL) connectée à l'électrode de source et s'étendant dans une seconde direction sur le substrat,
dans lequel chaque zone de pixel de la pluralité des zones de pixels est définie comme une zone entourée par la ligne de grille et la ligne de données.

9. Dispositif d'afficheur à cristaux liquides comprenant un substrat de transistor à couches minces selon n'importe quelle revendication précédente.
